# EUROPEAN PATENT SPECIFICATION

(11) **EP 0 558 795 B1**
(45) Date of publication and mention of the grant of the patent: **18.03.1998**
(21) Application number: 92113942.4
(22) Date of filing: 15.08.1992
(51) Int. Cl.: H01L 21/304

(54) **Method for producing semiconductor chips**
Methode zur Herstellung von Halbleiterchips
Procédé pour la fabrication de puces à semiconducteur

(30) Priority: 06.02.1992 JP 57152/92
(43) Date of publication of application: 08.09.1993
(73) Proprietor: MITSUBISHI DENKI KABUSHIKI KAISHA, Tokyo (JP)
(72) Inventor: Kashiwa, Takuo, c/o Mitsubishi Denki K.K., 4-chome, Itami-shi, Hyogo-ken (JP); Ishikawa, Takahide, c/o Mitsubishi Denki K.K., 4-chome, Itami-shi, Hyogo-ken (JP); Notani, Yoshihiro, c/o Mitsubishi Denki K.K., 4-chome, Itami-shi, Hyogo-ken (JP)
(74) Representative: KUHNEN, WACKER & PARTNER

(56) References cited:
- DE-A- 3 735 489
- IEEE TRANSACTIONS ON SEMICONDUCTOR MANUFACTURING vol. 4, no. 1, February 1991, NEW YORK, USA pages 66 - 68 E.Y. CHANG ET AL.
- PATENT ABSTRACTS OF JAPAN vol. 5, no. 176 (E-081)12 November 1981
- PATENT ABSTRACTS OF JAPAN vol. 13, no. 103 (E-725)10 March 1989

## Description

### FIELD OF THE INVENTION

The present invention relates to a method for producing semiconductor chips and, more particularly, to improved dicing lines along which a semiconductor wafer is divided into chips.

### BACKGROUND OF THE INVENTION

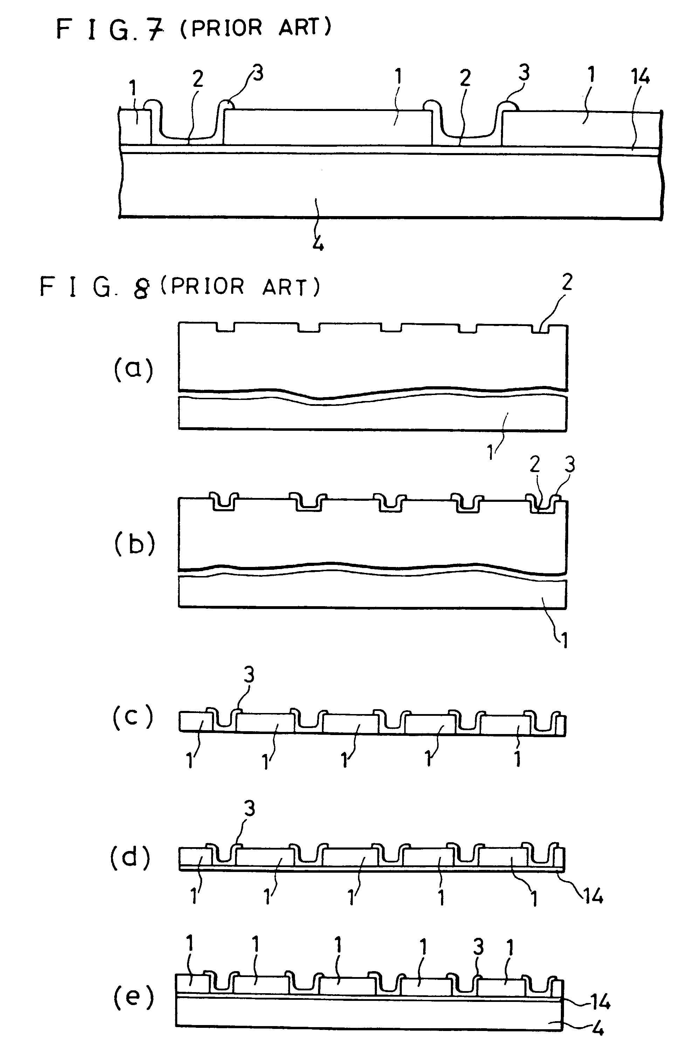

Figure 7 is a cross-sectional view of a conventional GaAs semiconductor wafer before a dicing process. Semiconductor substrates 1 are mechanically connected to each other by metal films 3 comprising gold or the like, so that an intensity of the whole wafer is increased. Each substrate is about 40 to 50 microns (1 micron = 1 micrometer) thick and has an active element and a passive element on its main surface. The metal films 3 are formed by electroless plating. An Au layer 4 is disposed on the rear surface of the wafer through a feeding layer 14, so that heat is efficiently radiated from heat generating elements (not shown) on the semiconductor substrates. The Au layer 4 is generally called as a plated heat sink (hereafter referred to as PHS).

A method for producing the semiconductor wafer of figure 7 is illustrated in figures 8(a)-8(e).

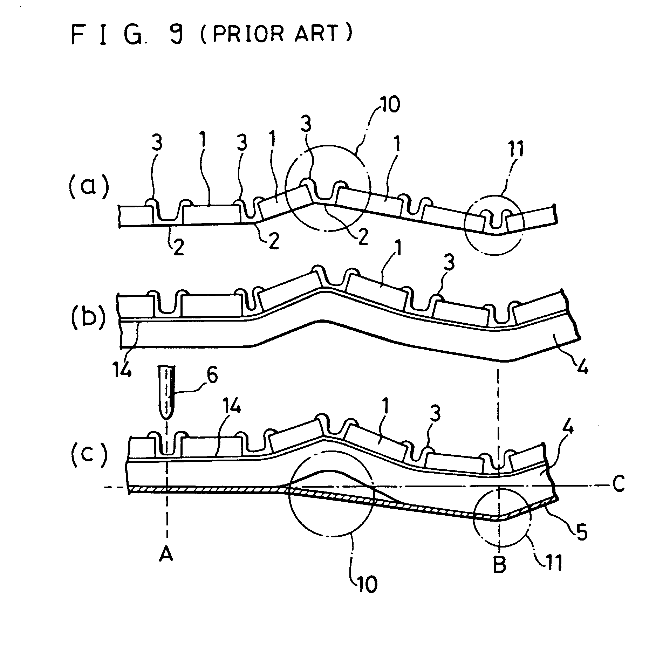

Initially, as illustrated in figure 9(a), a surface of the GaAs substrate 1 approximately 600 microns thick is partially etched away to form grooves 2 approximately 30 microns depth. The grooves 2 serve as dicing lines in a dicing process.

Then, as illustrated in figure 8(b), metal films 3 each having a thickness of 2 to 3 microns and comprising gold are formed in the grooves 2 by electroless plating. Thereafter, the GaAs substrate 1 is ground from the rear surface until the metal films 3 are exposed, resulting in a plurality of semiconductor substrates 1 connected to each other by the metal films 3 as shown in figure 8(c).

Then, as illustrated in figure 8(d), a feeding layer 14 approximately several microns thick comprising gold or the like is formed over the rear surface of the wafer. Then, as illustrated in figure 8(e), a PHS layer 4 approximately 40 microns thick is formed using the feeding layer 14.

In the conventional method for producing semiconductor chips, before the formation of the PHS layer 4, the GaAs substrates 1 are connected to each other by only the metal films 3, so that the intensity of the whole wafer is poor against a stress applied in the production process, such as a handling process. Therefore, as illustrated in figure 9(a), the metal film 3 unfavorably rises (portion 10 in the figure) or sinks (portion 11 in the figure), whereby the wafer unfavorably curves. Then, the feeding layer 14 and the plated heat sink 4 are formed on the rear surface of the curved wafer as illustrated in figure 9(b). When the wafer with the PHS layer 4 is cut by a blade 6 of a dicer (not shown) as illustrated in figure 9(c), if a depth of cut is adjusted to a line C at a point A, the blade 6 reaches only halfway in the PHS layer 4 at a point B due to the sinking portion 11, so that the dicing is not perfectly carried out. On the other hand, if the depth of cut is adjusted at the point B, a tape 5 applied to the PHS layer 4 is unfavorably cut at the point A, so that the dicing cannot be carried on, thereby reducing the production yield.

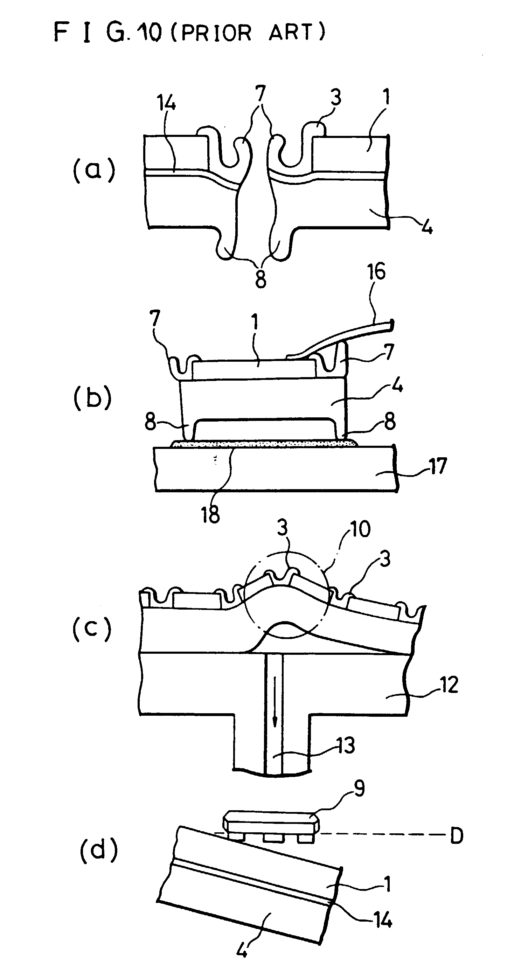

In addition, since the metal film 3 and the PHS layer 4, both comprising a relatively soft metal like gold, are present beneath the dicing line 2, burrs 7 and 8 are produced after the dicing as illustrated in figure 10(a). When such a semiconductor chip is mounted on a package 17 and a wire 16 is connected to elements on the substrate 1 as illustrated in figure 10(b), the wire 16 unfavorably contacts with the burr 7, causing a short circuit. In addition, solder 18 is not evenly adhered to the PHS layer 4 because of the burr 8, so that the chip is not precisely die-bonded, causing a misassembling.

Figures 10(c) and 10(d) illustrate process steps of measuring characteristics of elements on the GaAs substrate 1. In figure 10(c), the semiconductor wafer of figure 9(b) is put on a stage 12 and a hole 13 is made vacuous to fix the wafer onto the stage 12. However, because of the rising portion 10, the wafer cannot be fixed fast onto the stage 12. Even if the wafer is fixed onto the stage 12 somehow, the GaAs substrate 1 inclines with respect to a horizontal plane D as illustrated in figure 10(d). In this case, an RF probe terminal 9 does not favorably contact with the elements on the substrate 1, resulting in an inaccurate measurement.

Meanwhile, a method for dividing a semiconductor wafer into a plurality of chips by etching, a so-called pellet separation method, is employed in, for example, Japanese Published Patent Applications Nos. 62-122279, 2-148739, and 2-214127. In this method, although no burr is produced, it is difficult to control a dimension of each chip after the separation. In addition, the chips after the etching process are separated from each other, preventing a rapid transition to the subsequent die-bonding process. This results in a poor production yield. In addition, it is not possible to selectively pick out non-defective chips which are tested before the separation. Therefore, this method is not suitable for a process analysis.

From E. Y. Chang et al: IEEE Transactions on Semiconductor Manufacturing 4, (1991), no. 1, pages 66 to 68 a method for producing chips is known comprising the steps of forming grooves on the front side of the semiconductor substrate, grinding the substrate from the rear surface, forming a feeding layer, forming a PHS layer, forming saw streets on the rear surface through the PHS layer, the feeding layer and into the substrate, applying a dicing tape, and cutting the substrate along the dicing lines. Due to the saw streets positioned adjacent each other on the front and rear sufaces of the semiconductor substrate microcracks of the brittle substrate upon dicing of the substrate are omitted.

### SUMMARY OF THE INVENTION

It is an object of the present invention to provide a method for producing semiconductor chips in which a semiconductor substrate with PHS is flat and a depth cut by a blade is easily set in a dicing process.

It is another object of the present invention to provide a method for producing semiconductor chips in which the semiconductor substrate is fixed fast onto a wafer stage and an RF probe horizontally contacts with the semiconductor substrate in a process of measuring characteristics of elements on the substrate.

It is still another object of the present invention to provide a method for producing semiconductor chips in which production yield is improved and a sufficient junction can be achieved in a die-bonding process.

Other objects and advantages of the present invention will become apparent from the detailed description given hereinafter; it should be understood, however, that the detailed description and specific embodiment are given by way of illustration only..

According to an aspect of the present invention, in a method of producing semiconductor chips according to claim 1, a plurality of grooves serving as dicing lines are formed in a surface of a substrate and the substrate is ground from the rear surface so as to leave bottoms of the grooves. Then, a feeding layer is formed on the rear surface of the substrate. Then, a PHS layer is formed on the feeding layer opposite to the substrate. Then, the semiconductor substrate is divided into a plurality of chips using a dicing tape and a dicing blade. Therefore, an intensity of the substrate is increased because portions of the substrate and the feeding layer are present beneath the dicing lines. In addition, since the layers beneath the dicing lines are thin, burrs of the layers are reduced during the dicing.

### BRIEF DESCRIPTION OF THE DRAWINGS

Figure 1 is a cross-sectional view of a semiconductor wafer in accordance with a first embodiment of the present invention;
Figures 2(a)-2(d) are cross-sectional views of steps in a method for producing the semiconductor wafer of figure 1;
Figures 3(a)-3(b) are cross-sectional views of the semiconductor wafer of figure 1 in a dicing process;
Figures 4(a)-4(b) are cross-sectional views of the semiconductor wafer of figure 1 in a process of measuring characteristics;
Figure 5 is a cross-sectional view of a semiconductor wafer in accordance with a second embodiment of the present invention;
Figure 6 is a cross-sectional view of a semiconductor wafer in accordance with a third embodiment of the present invention;
Figure 7 is a cross-sectional view of a semiconductor wafer in accordance with the prior art;
Figures 8(a)-8(e) are cross-sectional view of steps in a method for producing the semiconductor wafer of figure 8;
Figures 9(a)-9(c) are cross-sectional views for explaining problems in a dicing process in accordance with the prior art; and
Figures 10(a)-10(d) are cross-sectional views for explaining problems in a die-bonding process and a process of measuring characteristics in accordance with the prior art.

### DETAILED DESCRIPTION OF THE PREFERRED EMBODIMENTS

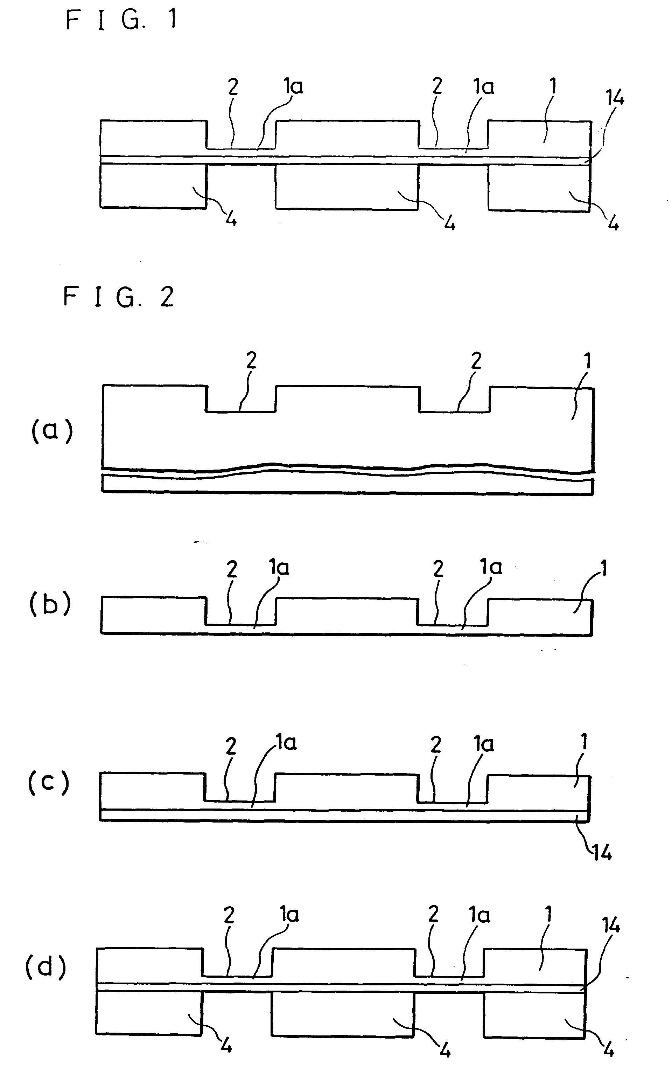

Figure 1 is a cross-sectional view of a semiconductor wafer in accordance with a first embodiment of the present invention. In figure 1, reference numeral la designates a portion of the GaAs substrate 1 remaining beneath the dicing line 2. PHS layers 4 are opposite to the substrate 1 with the feeding layer 14 between.

A method for producing the semiconductor wafer of figure 1 is illustrated in figures 2(a)-2(d).

Initially, as illustrated in figure 2(a), a surface of the GaAs substrate 1 approximately 600 microns thick is partially etched away by chemical to form grooves (dicing lines) 2 each having a depth of 10 to 15 microns.

Then, as illustrated in figure 2(b), the opposite surface of the substrate 1 is ground using a lathe machine or the like to reduce the thickness of the substrate 1 to approximately 30 microns. At this time, a portion 1a remaining beneath the groove 2 is 10 to 15 microns thick.

Then, as illustrated in figure 2(c), a feeding layer 14 several microns thick is formed over the rear surface of the substrate 1 by electroless plating using gold. Then, as illustrated in figure 2(d), PHS layers 4 are selectively formed on the feeding layer 14 except for regions beneath the grooves 2 using a photoresist (not shown) as a mask. Each PHS layer 4 is 40 to 50 microns thick.

According to the first embodiment of the present invention, when the GaAs substrate 1 is ground from the rear surface, the portions la 10 to 15 microns thick are left beneath the dicing lines 2 and then the feeding layer 14 is formed on the rear surface of the substrate. Since the portions la of the substrate and the feeding layer 14 are present beneath the dicing lines 2, an intensity of the whole wafer is increased and the wafer is not bent like the conventional wafer even if a stress is applied in a handling process or the like.

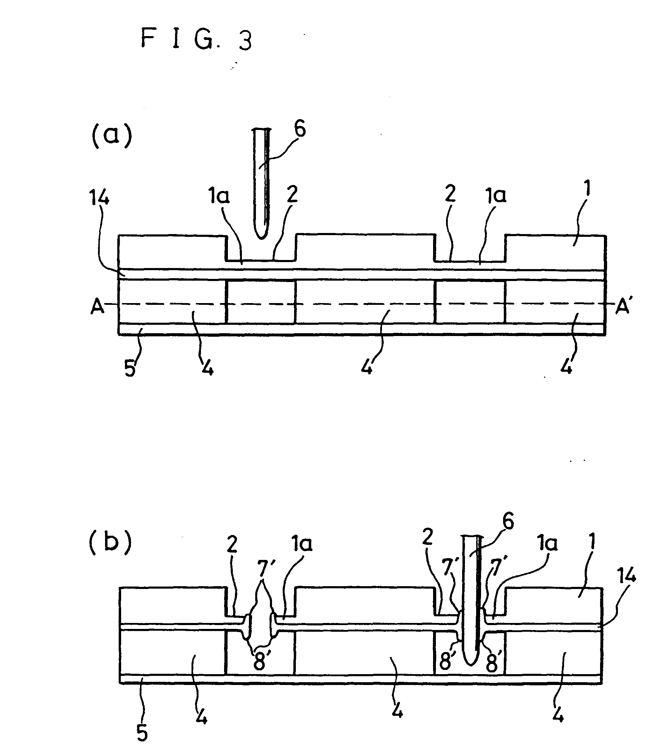

Figure 3(a) shows the semiconductor wafer of figure 1(d) in a dicing process. A dicing tape 5 is applied to the PHS layers 4. If a depth of cut by a blade 6 is adjusted to a line A-A' considering generation of burrs of the feeding layer 14, the same depth of cut is obtained through all dicing lines 2.

In addition, since the feeding layer 14 is only several microns thick, burrs 7' and 8' are so small that they never protrude from the upper and lower surfaces of the chip. Therefore, when the chip is mounted on a package, solder is evenly adhered to the PHS layer 4, resulting in an accurate die bonding. In addition, a short circuit does not occur when the chip is connected to an external device by a wire.

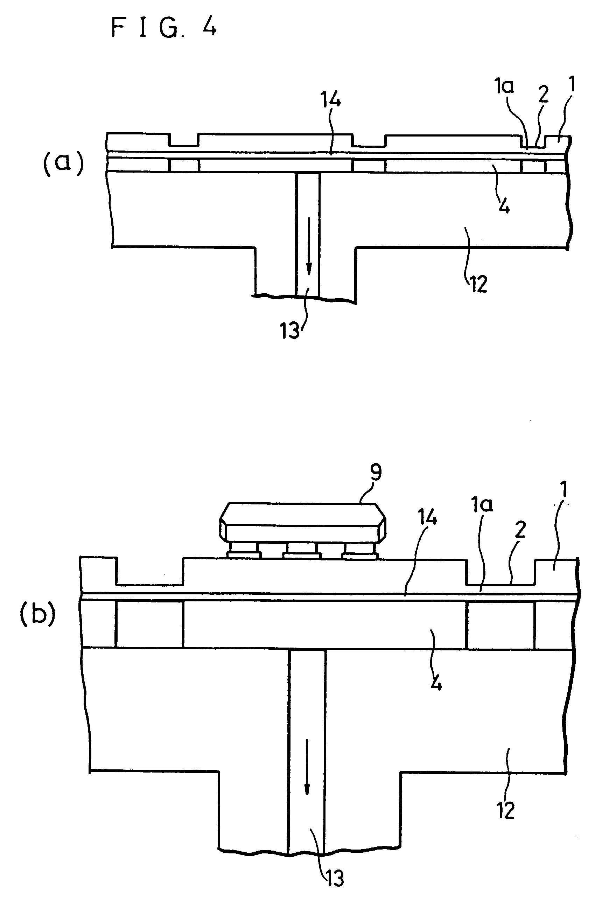

As illustrated in figure 4(a), when the semiconductor wafer is put on a stage 12 and fixed to the stage by making a hole 13 vacuous, since the substrate 1 is flat, it is fixed steadily and horizontally. Therefore, an RF probe 9 reliably contacts with the chip as shown in figure 4(b) and the test is carried out in a good condition.

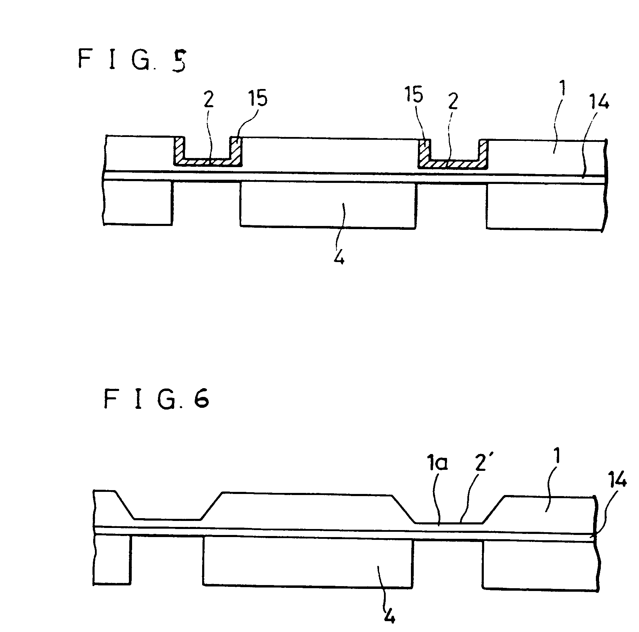

Figure 5 is a cross-sectional view of a semiconductor wafer in accordance with a second embodiment of the present invention. In this embodiment, WSi, SiO₂ or the like is selectively deposited on the dicing lines 2 to several thousands of angstroms by sputtering to form reinforcing films 15 which increase intensity of the wafer. These reinforcing films 15 are formed after the formation of the dicing lines 2 shown in figure 2(a), i.e., before the grinding of the substrate. Therefore, intensity of the wafer is further increased against a stress applied in the subsequent process steps. Preferably, the reinforcing film comprises a material having brittleness, such as WSi or SiO₂.

Figure 6 is a cross-sectional view of a semiconductor wafer in accordance with a third embodiment of the present invention. In this fourth embodiment, dicing lines 2' are formed by isotropic etching so that an angle of an upper end of each substrate 1 may be obtuse angle. Therefore, when the semiconductor chip is picked up with a pincette or the like after dicing, breakage of the chip is prevented, increasing production yield and reliability.

While in the above-illustrated embodiments GaAs is used for the substrate 1, other semiconductor materials, such as InP, may be used.

As is evident from the foregoing description, in a method of producing semiconductor chips according to the present invention, a plurality of grooves serving as dicing lines are formed in a surface of a substrate and the substrate is ground from the rear surface so as to leave bottoms of the grooves. Then, a feeding layer is formed on the rear surface of the substrate and a PHS layer is formed on the feeding layer. Then, the semiconductor substrate is divided into a plurality of chips using a dicing tape and a dicing blade. Therefore, an intensity of the substrate is increased because portions of the substrate remain beneath the dicing lines, preventing curvature of the substrate. Therefore, a depth of cut is easily set in the dicing process. In addition, characteristics of elements on the substrate are measured with high precision.

In addition, a PHS layer is selectively formed on the feeding layer except for regions beneath the dicing lines. Therefore, only the thin portions of the substrate and the feeding layer are present beneath the dicing lines, so that burrs produced during dicing are reduced and a sufficient junction is achieved in the subsequent die-bonding process, resulting in high production yield.

## Claims

1. A method of producing semiconductor chips comprising the following steps:
a) forming grooves (2) serving as dicing lines in a front surface region of a semiconductor substrate (1) comprising a circuit;
b) grinding said semiconductor substrate (1) from the rear surface to a prescribed thickness, leaving portions (1a) of a prescribed thickness beneath said dicing lines;
c) forming a feeding layer (14) over the rear surface of the substrate (1);
d) selectively forming a metal layer (4) for heat radiation on said feeding layer (14) except for regions beneath the dicing lines;
e) applying a dicing tape (5) to said metal layer (4); and
f) cutting through said substrate (1) and said feeding layer (14) along said dicing lines with a dicing blade (6) to produce said plurality of semiconductor chips.

2. The method of claim 1, wherein brittle reinforcing layers (15) are formed in said grooves (2).

3. The method of one of the previous claims wherein each groove (2) has a reverse-trapezoid cross section.

4. The method of one of the previous claims wherein the characteristics of said circuit on said substrate (1) are measured after forming said metal layer (14).

5. The method of one of the previous claims wherein said grooves (2) have a depth of 10 to 15 microns, and portions (1a) beneath said dicing lines have a thickness of 10 to 15 microns.

## Patentansprüche

1. Herstellungsverfahren von Halbleiterchips, welches die folgenden Schritte aufweist:
a) Ausbilden von als Schnittlinien dienende Nuten (2) in einem vorderseitigen Oberflächenbereich eines Halbleitersubstrates (1), welches eine Schaltung enthält;
b) Schleifen des Halbleitersubstrates (1) auf der Rückseite bis auf eine vorgeschriebene Dicke, so daß Abschnitte einer vorgeschriebenen Dicke unterhalb der Schnittlinien verbleiben;
c) Ausbilden einer Zuführungsschicht (14) über die Rückseite des Substrates (1);
d) Selektives Ausbilden einer Metallschicht (4) zur Wärmeabstrahlung auf der Zuführungsschicht (14), außer in Bereiche unterhalb der Schnittlinie;
e) Anlegen eines Schnittbandes (5) auf die Metallschicht (4); und
f) Durchschneiden des Substrates (1) und der Zuführungsschicht (14) entlang der Schnittlinie mit einer Schneide (6), um mehrere Halbleiterchips herzustellen.

2. Verfahren nach Anspruch 1, bei dem spröde Verstärkungsschichten (15) in den Nuten (2) ausgebildet werden.

3. Verfahren nach einem der vorangehenden Ansprüche, wobei jede Nut (2) einen Querschnitt mit umgedrehtem Trapez aufweist.

4. Verfahren nach einem der vorangehenden Ansprüche, wobei die Charakteristik der Schaltung auf dem Substrat (1) nach dem Ausbilden der Metallschicht (14) gemessen wird.

5. Verfahren nach einem der vorangehenden Ansprüche, wobei die Nuten (2) eine Tiefe von 10 bis 15 µm aufweisen, und die Abschnitte (1a) unterhalb der Schnittlinien eine Dicke von 10 bis 15 µm aufweisen.

## Revendications

1. Procédé de production de puces à semi-conducteur comprenant les étapes suivantes :
a) former des rainures (2) servant comme lignes de découpe dans une région de surface avant d'un substrat semi-conducteur (1) comprenant un circuit;
b) rectifier ledit substrat semi-conducteur (1) à partir de la surface arrière à une épaisseur prescrite, laissant des portions (1a) d'une épaisseur prescrite sous lesdites lignes de découpe;
c) former une couche d'alimentation (14) sur la surface arrière du substrat (1);
d) sélectivement former une couche métallique (4) de rayonnement thermique sur ladite couche d'alimentation (14) à l'excepté des régions sous les lignes de découpe;
e) appliquer une bande de découpe (5) à ladite couche métallique (4); et
f) couper à travers ledit substrat (1) et ladite couche d'alimentation (14) le long desdites lignes de découpe avec une lame de découpe (6) pour produire ladite pluralité de puces à semi-conducteur.

2. Procédé selon la revendication 1, dans lequel des couches de renforcement cassantes (15) sont formées dans les rainures précitées (2).

3. Procédé de l'une des revendications précédentes dans lequel chaque rainure (2) a une section en trapèze inversé.

4. Procédé de l'une des revendications précédentes dans lequel les caractéristiques du circuit précité sur le substrat précité (1) sont mesurées après avoir formé la couche métallique précitée (14).

5. Procédé de l'une des revendications précédentes dans lequel les rainures précitées (2) ont une profondeur de 10 à 15 microns et les portions précitées (1a) sous les lignes de découpe précitées ont une épaisseur de 10 à 15 microns.
